# EUROPEAN PATENT APPLICATION

(11) **EP 4 782 264 A1**
(43) Date of publication of application: **29.07.2026**
(21) Application number: 26151483.0
(22) Date of filing: 13.01.2026
(51) Int. Cl.: B60L 58/00, B60L 58/12, B60L 58/16, G01R 31/392, B60L 3/00, B60L 58/10, B60L 3/12

(54) **PROCESSING DEVICE, STORAGE BATTERY SYSTEM, AND STORAGE BATTERY CONTROL DEVICE**

(30) Priority: 23.01.2025 JP 2025009568
(71) Applicant: KABUSHIKI KAISHA TOSHIBA, Kawasaki-shi, Kanagawa (JP)
(72) Inventor: KOGAWA, Tsuyoshi, Kawasaki-shi, Kanagawa (JP); SHIJO, Tetsu, Kawasaki-shi, Kanagawa (JP)
(74) Representative: Hoffmann Eitle

(57) **Abstract**

According to one arrangement, a processing device (20) receives first deterioration information on a power storage module (111) from a first controller (112) connected to the power storage module (111). The processing device (20) receives second deterioration information on the power storage module (111) from a second controller that is connected to the first controller (112) and directly or indirectly controls the first controller (112). The processing device (20) compares the first deterioration information with the second deterioration information, and outputs output information on whether there is a possibility that the first deterioration information or the second deterioration information has been falsified.

## Description

### FIELD

The present disclosure relates to a processing device, a storage battery system, and a storage battery control device.

### BACKGROUND

In the EU, it is known that Regulation (EU) 2023/1542 has been formulated as one of efforts to reduce greenhouse gas emissions to substantially zero. Regulation (EU) 2023/1542 is a rule for ensuring sustainability over the entire life cycle of a storage battery, as part of which a battery passport was introduced. The battery passport is a digital certificate for ensuring traceability of the storage battery. As a mechanism of the battery passport, for example, a mechanism is conceivable in which traceability is secured by passing data related to the storage battery such as manufacturing information, technical information, and performance data of the storage battery to a third-party authentication organization that operates the battery passport. Note that, in Japan, a mechanism like the battery passport has been studied.

For the mechanism to function normally for ensuring the traceability of the storage battery as described above, it is necessary to ensure reliability that data related to the storage battery is not falsified.

### BRIEF DESCRIPTION OF THE DRAWINGS

FIG. 1 is a block diagram illustrating a configuration example of a storage battery system according to a first arrangement.
FIG. 2 is a block diagram showing a configuration example of a power storage system in a first arrangement.
FIG. 3 is a block diagram illustrating a configuration example of a processing device according to the first arrangement.
FIG. 4 is a diagram illustrating an example of a hardware configuration of the processing device according to the first arrangement.
FIG. 5 is a diagram illustrating an example of a deterioration information management table stored in a storage of the processing device according to the first arrangement.
FIG. 6 is a flowchart illustrating an example of a flow of comparison processing of the processing device according to the first arrangement.
FIG. 7 is a block diagram showing a configuration example of a power storage system in a first modification.
FIG. 8 is a block diagram showing a configuration example of a power storage system in a second modification.
FIG. 9 is a diagram illustrating a configuration example of a storage battery system according to a second arrangement.
FIG. 10 is a block diagram illustrating a configuration example of a power storage system according to a third arrangement.

### DETAILED DESCRIPTION

According to one arrangement, a processing device receives first deterioration information on a power storage module from a first controller connected to the power storage module. The processing device receives second deterioration information on the power storage module from a second controller that is connected to the first controller and directly or indirectly controls the first controller. The processing device compares the first deterioration information with the second deterioration information, and outputs output information on whether there is a possibility that the first deterioration information or the second deterioration information has been falsified.

Hereinafter, arrangements will be described with reference to the drawings.

Note that the disclosure is merely an example, and the invention is not limited by the content described in the following arrangements. Modifications which a person skilled in the art could easily conceive are naturally included in the scope of the disclosure. In order to make the description clearer, a size, a shape, and the like of each part may be schematically represented by being changed from those of the actual arrangement in the drawings. In the plurality of drawings, corresponding elements are denoted by the same reference numerals, and a detailed description thereof may be omitted.

### (First arrangement)

First, a first arrangement will be described.

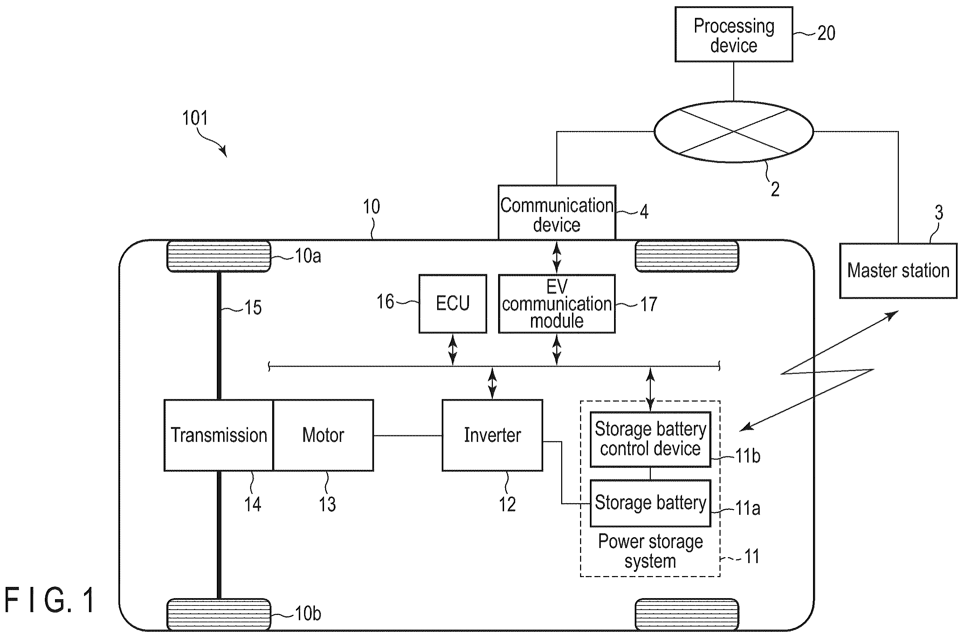

FIG. 1 is a block diagram illustrating a configuration example of a storage battery system 101 according to a first arrangement.

In recent years, a mechanism for ensuring sustainability over the entire life cycle of a storage battery, such as a battery passport, has been considered. However, the data on the storage battery has, for example, a risk that a storage battery manufacturer falsifies to increase the value of its own storage battery or a risk that a storage battery manufacturer falsifies to lower the value in order to encourage replacement of the storage battery. In addition, when a system equipped with a storage battery is sold as a used system, there is a risk that a seller falsifies data in order to sell the system at a high price. Further, when the storage battery is sold as a used unit without being incorporated in the system, there is a risk that a seller falsifies data in order to sell the storage battery at a high price. When such data falsification is performed, a mechanism for ensuring the sustainability of the storage battery cannot be correctly operated.

The storage battery system 101 according to the first arrangement is used to detect falsification of data related to the storage battery as described above. In the following description, an example for detecting falsification of data related to a storage battery mounted on an electric vehicle (EV) will be described.

The storage battery system 101 includes an EV system 10, a processing device 20, a master station 3, and a communication device 4. The EV system 10 is communicably connected to the communication device 4 by wire. The communication device 4 is communicably connected to the processing device 20 via the Internet 2. In addition, the EV system 10 is communicably connected to the master station 3 by wireless. The master station 3 may be a master station (master) for Bluetooth (registered trademark) Low Energy (BLE) communication. The master station 3 is communicably connected to the processing device 20 via the Internet 2.

The EV system 10 is a system for operating the EV by the power of a storage battery 11a. The EV system 10 includes, for example, a power storage system 11, an inverter 12, a motor 13, a transmission 14, a drive shaft 15, an electronic control unit (ECU) 16, and an EV communication module 17. The ECU 16, the EV communication module 17, the inverter 12, and the power storage system 11 are connected by, for example, a bus or the like, and can communicate with each other via a controller area network (CAN).

The ECU 16 controls the power storage system 11, the inverter 12, and the EV communication module 17 in order to operate the EV. Specifically, the ECU 16 outputs a control command to the power storage system 11 to perform control for storing power in the storage battery 11a.

Note that, in the following description, in a case where two modules are in a relationship in which one module directly or indirectly controls the other module, the module to be controlled is described as being in a "lower level" than the other module. Similarly, the module on the control side is described as being in a "higher level" than the other module. Herein, it can be said that the ECU 16 is in a higher level than the power storage system 11(more specifically, power storage controller 112 included in the power storage system 11).

In addition, the ECU 16 supplies the electric power stored in the storage battery 11a to the inverter 12. Further, the ECU 16 outputs a control command to the inverter 12 to drive the motor 13. A rotation shaft of the motor 13 is connected to the transmission 14. The transmission 14 is connected to the drive shaft 15 of tires 10a and 10b. The transmission 14 rotates the drive shaft 15 (that is, the tires 10a and 10b) along with the driving of the motor 13.

Further, the ECU 16 transmits information on the EV to the processing device 20 via the EV communication module 17 and the communication device 4. The information on the EV includes information on the storage battery 11a (more specifically, power storage module 111 to be described later) provided in the EV and time information indicating the time when the information on the storage battery 11a is acquired.

The information on the storage battery 11a includes, for example, a temperature of each cell included in the storage battery 11a, a temperature of the entire storage battery 11a, the number of times of charging, a state of charge (SOC), a state of health (SOH), abnormality flag information (information indicating a state of a flag that is turned on when there is overcharge, overdischarge, overcurrent, or the like of the battery), a voltage range, an operation time, a resistance value, a capacity, a resistance change rate, a capacity change rate, a maximum operation temperature, a minimum operation temperature, an integrated current use amount, and a battery use strength. The battery use strength is, for example, a ratio of a charge-discharge current to a rated capacity. The battery use strength may be a ratio of the integrated current use amount to the use time or a ratio of the integrated current use amount to the use average voltage. Hereinafter, the information on the storage battery 11a as described above is referred to as "deterioration information" of the storage battery 11a.

For example, the ECU 16 acquires information such as a voltage applied to each cell of the storage battery 11a and a temperature of each cell from the power storage system 11. The ECU 16 generates (counts, calculates, or detects) deterioration information of the storage battery 11a based on the acquired information. Then, the ECU 16 transmits information on the EV to the processing device 20 via the EV communication module 17 and the communication device 4. The information on the EV includes the generated deterioration information of the storage battery 11a. Note that the ECU 16 may acquire deterioration information of the storage battery 11a from the power storage system 11. In addition, the ECU 16 may store the deterioration information of the storage battery 11a in a storage (not illustrated) connected to the ECU 16 in the EV system 10. In this case, the ECU 16 reads the deterioration information of the storage battery 11a from the storage, and transmits the deterioration information to the processing device 20 via the EV communication module 17 and the communication device 4.

The EV communication module 17 includes an On-Board Diagnostics Second Generation (OBD2) port. The EV communication module 17 communicates with the communication device 4 provided outside the EV system 10 via the OBD2 port. In the present arrangement, the EV communication module 17 receives an input of information on the EV from the ECU 16 and transmits the information to the communication device 4.

The communication device 4 receives the information on the EV via the EV communication module 17 and transmits the information to the processing device 20 via the Internet 2. Note that the communication device 4 may be an OBD2 scan tool.

The power storage system 11 stores electric power in the storage battery 11a based on a control command from the ECU 16. In addition, the power storage system 11 supplies the power stored in the storage battery 11a to the inverter 12 based on a control command from the ECU 16.

In addition, the power storage system 11 transmits information on the storage battery 11a to the processing device 20 via the master station 3. The information on the storage battery 11a includes the deterioration information on the storage battery 11a and the time information when the deterioration information is acquired. The time information can be acquired by a timer (not illustrated).

The processing device 20 is an information processing device that performs processing for detecting falsification of the deterioration information of the storage battery 11a (more specifically, power storage module 111 to be described later) by the EV system 10 or the power storage system 11. The processing device 20 may be implemented by, for example, a cloud server.

In addition, the processing device 20 receives deterioration information (first deterioration information) of the storage battery 11a from the power storage system 11 via the master station 3. Specifically, the processing device 20 transmits a request signal for requesting deterioration information on the storage battery 11a to the power storage system 11 via the master station 3. The power storage system 11 transmits the deterioration information on the storage battery 11a to the processing device 20 in response to the request signal. Therefore, the processing device 20 receives the deterioration information on the storage battery 11a from the power storage system 11 in response to the request signal. The processing device 20 may transmit the request signal to the power storage system 11 at a predetermined cycle. Alternatively, the power storage system 11 may transmit the deterioration information of the storage battery 11a to the processing device 20 via the master station 3 in response to an operation (button pressing or the like) of a user interface (not illustrated) provided in the power storage system 11.

The processing device 20 receives the information on the EV and the deterioration information (second deterioration information) of the storage battery 11a included in the information on the EV from the ECU 16 of the EV system 10 via the EV communication module 17 and the communication device 4. Specifically, the processing device 20 transmits a request signal for requesting information on the EV to the EV system 10 via the communication device 4. The EV system 10 transmits the deterioration information on the storage battery 11a to the processing device 20 in response to the request signal. Therefore, the processing device 20 receives the deterioration information of the storage battery 11a included in the information on the EV from the EV system 10 in response to the request signal. The processing device 20 may transmit the request signal to the EV system 10 at a predetermined cycle. Alternatively, the communication device 4 may transmit a request signal for requesting information on the EV to the EV system 10 in response to an operation (button pressing or the like) of a user interface (not illustrated) provided in the communication device 4. The EV system 10 transmits the deterioration information on the storage battery 11a to the communication device 4 in response to the request signal. Therefore, the communication device 4 may receive the deterioration information of the storage battery 11a included in the information on the EV from the EV system 10 in response to the request signal, and transmit the deterioration information received from the EV system 10 to the processing device 20.

Then, the processing device 20 compares the deterioration information of the storage batteries 11a received from the power storage system 11 with the deterioration information of the storage batteries 11a received from the EV system 10, generates output information on whether there is a possibility that one of the two pieces of deterioration information of the storage batteries 11a has been falsified, and outputs the output information. The output information may be, for example, text information, image information, audio information, or a combination thereof.

The output destination of the output information may be a monitor device (not illustrated) connected to the communication device 4 or a monitor device (not illustrated) connected to the master station 3. Alternatively, the output destination of the output information may be a terminal or the like connected via the Internet 2 or the like and used by a predetermined surveillance staff. Hereinafter, the output information output in a case where there is a possibility that one of the two pieces of deterioration information of the storage batteries 11a is falsified may be referred to as an "alert".

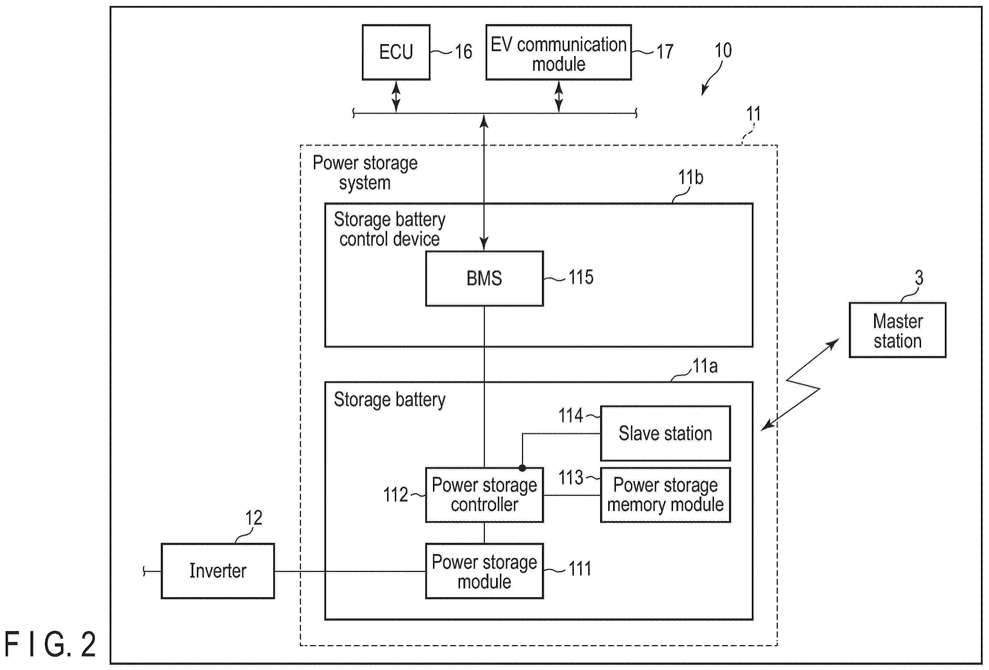

FIG. 2 is a block diagram showing a configuration example of the power storage system 11 in the first arrangement. As described above, the power storage system 11 includes the storage battery 11a and the storage battery control device 11b.

The storage battery 11a includes a power storage module 111, a power storage controller 112, a power storage memory module 113, and a slave station 114. The power storage module 111 includes a plurality of cells, a plurality of charge switches for charging each cell, a discharge switch for discharging each cell, a cell temperature sensor for measuring a cell temperature, and the like.

The power storage controller 112 controls the charge switches and the discharge switches in response to a control command from the storage battery control device 11b.

In addition, the power storage controller 112 monitors the power storage module 111. Monitoring of the power storage module 111 means, for example, acquiring the voltage applied to each cell, the temperature of each cell from the power storage module 111 at predetermined time intervals. Hereinafter, information obtained by monitoring is referred to as "monitoring information".

The power storage controller 112 writes the monitoring information in the power storage memory module 113 together with time information indicating time when the monitoring information is acquired and manufacturing information of the power storage module 111. The time information can be acquired from, for example, a timer (not illustrated). In addition, the power storage controller 112 generates (counts, calculates, or detects) deterioration information of the power storage module 111 based on the monitoring information, and writes the deterioration information in the power storage memory module 113 together with time information and manufacturing information of the power storage module 111. Note that the manufacturing information of the power storage module 111 may be written previously in a read only memory (ROM) (not illustrated). In this case, the power storage controller 112 may not write the manufacturing information of the power storage module 111 in the power storage memory module 113.

In response to a request signal for monitoring information from the storage battery control device 11b, the power storage controller 112 reads the corresponding monitoring information from the power storage memory module 113, and outputs the monitoring information to the storage battery control device 11b together with time information and manufacturing information of the power storage module 111. In addition, when receiving the request signal of the deterioration information of the power storage module 111 from the processing device 20 through the master station 3 and the slave station 114, the power storage controller 112 reads the deterioration information of the power storage module 111 stored in the power storage memory module 113, and transmits the same to the processing device 20 through the slave station 114 and the master station 3 together with time information and manufacturing information of the power storage module 111.

Note that the power storage controller 112 may be obtained by adding functions of writing to and reading from the power storage memory module 113 and a function of controlling the slave station 114 to a cell monitoring unit (CMU). In addition, the power storage controller 112 may periodically write the deterioration information of the power storage module 111 to the power storage memory module 113, or may write the deterioration information of the power storage module 111 to the power storage memory module 113 in response to a control command from the battery management system (BMS) 115 or a control command from the ECU 16.

The slave station 114 is connected to the power storage controller 112 and the master station 3. The slave station 114 may be a slave station (slave) for BLE communication. The slave station 114 transmits the deterioration information of the power storage module 111 output from the power storage controller 112 to the processing device 20 via the master station 3 and the Internet 2.

The power storage memory module 113 stores monitoring information of the power storage module 111 and deterioration information of the power storage module 111.

The storage battery control device 11b includes a BMS 115. The BMS 115 outputs a control command to the charge switch and the discharge switch of each cell to the power storage controller 112 of the storage battery 11a based on the monitoring information output from the storage battery 11a and the control command output from the ECU 16 of the EV system 10. In addition, the BMS 115 outputs monitoring information to the ECU 16 based on a request signal output from the ECU 16. The BMS 115 may generate deterioration information on the power storage module 111 from the monitoring information, and output the deterioration information on the power storage module 111 to the ECU 16.

That is, the power storage controller 112 of the storage battery 11a is controlled (indirectly) by the ECU 16 of the EV system 10 via the BMS 115 of the storage battery control device 11b. That is, it can be said that the power storage controller 112 of the storage battery 11a is in a lower level than the ECU 16 of the EV system 10.

In the following description, among pieces of the deterioration information of the power storage module 111 received by the processing device 20, the deterioration information of the power storage module 111 acquired by a module in a lower level (herein, the power storage controller 112) is referred to as "first deterioration information". In addition, among pieces of the deterioration information of the power storage module 111 received by the processing device 20, the deterioration information on the power storage module 111 acquired by a module in a higher level (herein, the ECU 16) is referred to as "second deterioration information".

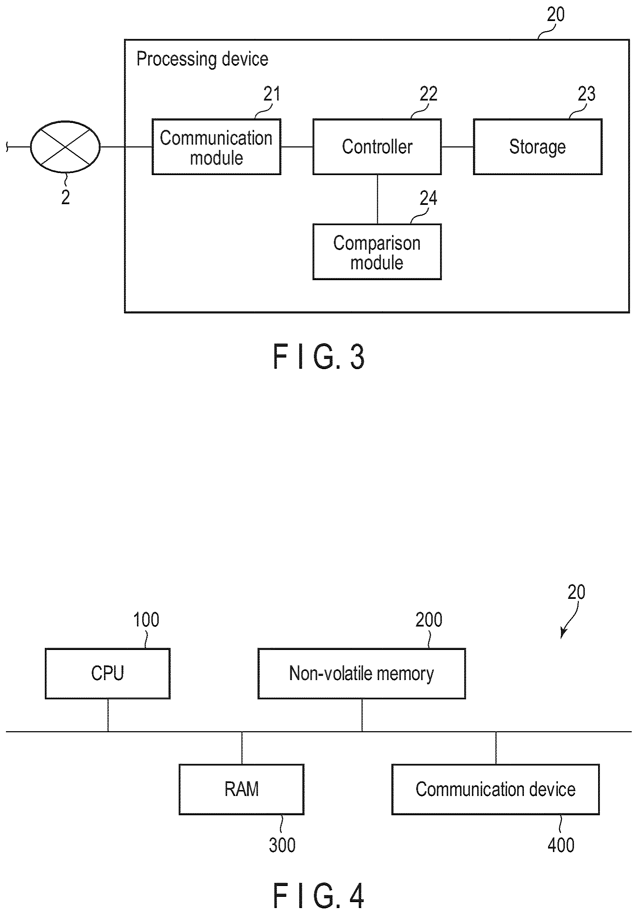

FIG. 3 is a block diagram illustrating a configuration example of the processing device 20 according to the first arrangement. The processing device 20 includes a communication module 21, a controller 22, a storage 23, and a comparison module 24.

The communication module 21 is connected to the Internet 2 and the controller 22. The communication module 21 outputs data received via the Internet 2 to the controller 22. The data received from the Internet 2 is, for example, the first deterioration information transmitted from the power storage controller 112 of the power storage system 11, and the second deterioration information transmitted from the ECU 16 of the EV system 10. In addition, the communication module 21 outputs a data read request to the controller 22. The data read request is a request to read date stored in the storage 23. The data read request transmitted from, for example, a terminal of an administrator (not illustrated).

In addition, the communication module 21 transmits the request signal of the deterioration information of the power storage module 111, the request signal output from the controller 22, to the EV system 10 connected to the communication device 4 and the power storage system 11 connected to the master station 3. In addition, a comparison result between the first deterioration information and the second deterioration information (an alert output command or the like) is transmitted to a monitor device connected to the communication device 4, the master station 3, a terminal of a surveillance staff, or the like via the Internet 2.

The controller 22 controls the entire processing for detecting whether or not the first deterioration information or the second deterioration information has been falsified. The controller 22 generates a request signal of deterioration information of the power storage module 111 at a constant cycle, and outputs the request signal to the communication module 21.

The controller 22 writes the data (the first deterioration information and the second deterioration information) transmitted in response to the request signal to the storage 23. In addition, the controller 22 reads, from the storage 23, deterioration information of the power storage module 111 necessary for detecting whether or not the first deterioration information or the second deterioration information has been falsified, and outputs the read deterioration information to the comparison module 24.

In addition, the controller 22 receives an input of the comparison result between the first deterioration information and the second deterioration information from the comparison module 24, and outputs the comparison result to the communication module 21. Note that, when the comparison result indicating that the first deterioration information and the second deterioration information are different from each other is output from the comparison module 24, the controller 22 may generate an alert output command and output the generated alert output command to the communication module 21. Alternatively, the controller 22 may write the comparison result to the storage 23.

Further, the controller 22 reads the corresponding data from the storage 23 in response to the data read request output from the communication module 21, and outputs the data to the communication module 21.

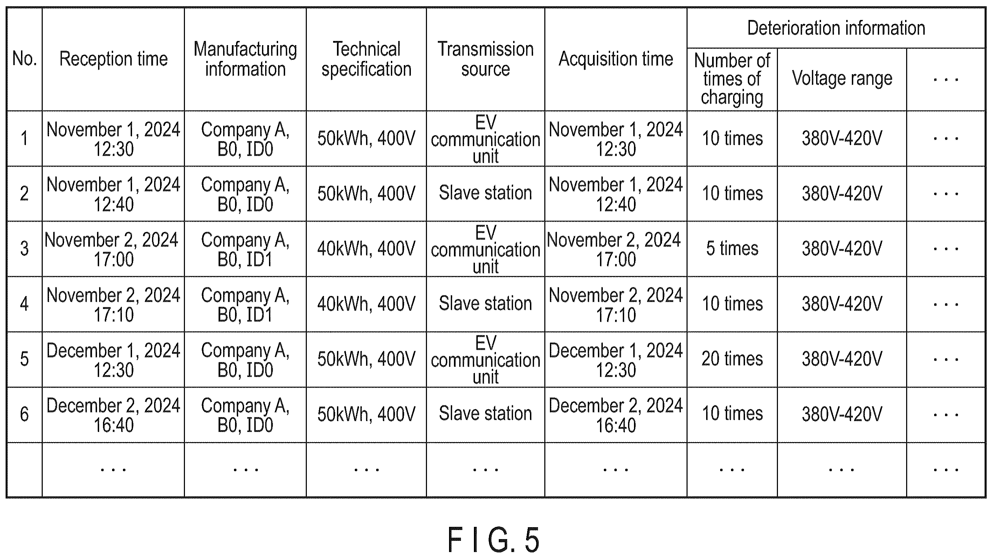

The storage 23 stores various data necessary for processing of the processing device 20. The data stored in the storage 23 includes at least a deterioration information management table. The deterioration information management table is a table for managing the first deterioration information and the second deterioration information (refer to FIG. 5).

The comparison module 24 compares a plurality of pieces of data (the first deterioration information and the second deterioration information) output from the controller 22. Then, the comparison module 24 outputs the comparison result to the controller 22. The comparison result indicating whether there is a possibility that the first deterioration information or the second deterioration information has been falsified as a result of comparing the pieces of input data.

FIG. 4 is a diagram illustrating a hardware configuration example of the processing device 20.

The processing device 20 includes, for example, a CPU 100, a non-volatile memory 200, a RAM 300, and a communication device 400.

The CPU 100 is a processor for controlling the operation of the processing device 20. The CPU 100 is at least one processor. The CPU 100 executes various programs loaded from the non-volatile memory 200 to the RAM 300. These programs include an operating system (OS) and various application programs.

The non-volatile memory 200 is a storage medium used as an auxiliary storage device. The non-volatile memory 200 can be used as a storage area for various types of information stored by the storage 23. Although only the non-volatile memory 200 is illustrated in FIG. 4, the processing device 20 may include other storage devices such as a hard disk drive (HDD) and a solid state drive (SSD).

The RAM 300 is a storage medium used as a main storage device. The RAM 300 can be used as a temporary storage area of data used for processing by the processing device 20.

The communication device 400 is a device configured to perform wired communication or wireless communication. The communication device 400 includes, for example, a reception unit that receives data from the outside and a transmission unit that transmits data (signal) to the outside. The reception unit can receive data from each of at least the EV system 10 and the power storage system 11. The transmission unit can transmit data to each of the communication device 4, the master station 3, and a terminal of a surveillance staff, for example.

Note that a part or all of the communication module 21, the controller 22, the storage 23, and the comparison module 24 illustrated in FIG. 3 are implemented by causing the CPU 100 to execute a predetermined program, that is, by software. This program may be stored in a computer-readable storage medium and distributed, or may be downloaded to the processing device 20 through a network. Note that a part or all of the communication module 21, the controller 22, the storage 23, and the comparison module 24 may be implemented by dedicated hardware or the like, or may be implemented by a combination of software and hardware.

FIG. 5 is an example of a deterioration information management table stored by the storage 23 of the processing device 20. The deterioration information management table includes a plurality of pieces of deterioration information and a plurality of entries corresponding thereto. Each of the entries includes fields indicating, for example, "No.", "reception time", "manufacturing information", "technical specification", "transmission source", "acquisition time of deterioration information", and " deterioration information".

The "No." corresponding to certain deterioration information indicates the order in which the deterioration information is acquired.

The "reception time" corresponding to certain deterioration information indicates date and time when the processing device 20 receives the deterioration information.

The "manufacturing information" corresponding to certain deterioration information indicates a manufacturer (maker), a model number, a unique number, and the like of the power storage module 111 related to the deterioration information.

The "technical specification" corresponding to certain deterioration information indicates the capacity and voltage of the power storage module 111 related to the deterioration information.

The "transmission source" corresponding to certain deterioration information indicates a transmission source that has transmitted the deterioration information. In the example of FIG. 5, the "transmission source" is the EV communication module 17 of the EV system 10 or the slave station 114 of the storage battery 11a. In the present arrangement, the fact that the "transmission source" is set to the "slave station" indicates that the deterioration information is the first deterioration information transmitted by the power storage controller 112 of the storage battery 11a. In addition, the fact that the "transmission source" is set to the "EV communication module" indicates that the deterioration information is the second deterioration information transmitted by the ECU 16 of the EV system 10. Note that the "transmission source" may be indicated by the communication device 4 and the master station 3. In addition, the "transmission source" may be indicated by, for example, an address of the transmission source.

The "acquisition time" corresponding to certain deterioration information indicates a time when the power storage controller 112 of the storage battery 11a or the ECU 16 of the EV system 10 acquires the deterioration information. Alternatively, the time may be a time at which the deterioration information is written to the power storage memory module 113.

The "deterioration information" corresponding to certain deterioration information indicates details of the deterioration information. In the example of FIG. 5, the "deterioration information" indicates fields indicating "number of times of charging" and "voltage range". The "number of times of charging" indicates the number of times the power storage module 111 has been charged from the start of use of the target power storage module 111 until the deterioration information is acquired. The "voltage range" indicates a voltage range from the start of use of the target power storage module 111 until the deterioration information is acquired. Although only the "number of times of charging" and the "voltage range" are illustrated in FIG. 5, the "deterioration information" may have more fields indicating information on the power storage module 111.

Then, the specific example of the comparison processing performed by the processing device 20 will be described. In addition, in the following description, deterioration information in which "No." on the deterioration information management table is set to X (X is a natural number) is referred to as "No. X deterioration information".

For example, it is assumed that the processing device 20 receives No. 1 deterioration information in FIG. 5. In this case, the processing device 20 does not perform the comparison because no other deterioration information to be compared is stored.

Then, it is assumed that the processing device 20 receives No. 2 deterioration information. Both the "manufacturing information" of the No. 2 deterioration information and the "manufacturing information" of the No. 1 deterioration information are "Company A (manufacturer), B0 (model number), ID0 (unique number)". In addition, the "transmission source" of the No. 1 deterioration information is the "EV communication module", and the "transmission source" of the No. 2 deterioration information is the "slave station". That is, the No. 1 deterioration information and the No. 2 deterioration information are the deterioration information on the same power storage module 111 acquired by different modules and transmitted from different transmission sources.

In this case, the processing device 20 compares the No. 1 deterioration information with the No. 2 deterioration information. In the example of FIG. 5, the "number of times of charging" of both the No. 1 deterioration information and the No. 2 deterioration information is "10 times". In addition, the "voltage range" of both the No. 1 deterioration information and the No. 2 deterioration information is "380 V to 420 V". That is, the No. 1 deterioration information and the No. 2 deterioration information are the same. Therefore, the possibility that the No. 1 deterioration information and the No. 2 deterioration information are falsified is low, and thus the processing device 20 does not output an alert.

Then, it is assumed that the processing device 20 receives No. 3 deterioration information. The "manufacturing information" of the No. 3 deterioration information is "Company A, B0, ID1", and is different from the "manufacturing information" of the No. 1 deterioration information and the No. 2 deterioration information. In this case, there is no data with the same manufacturing information, and thus the processing device 20 does not perform comparison.

Then, it is assumed that the processing device 20 receives No. 4 deterioration information. The "manufacturing information" of the No. 4 deterioration information is "Company A, B0, ID1", which is the same as the "manufacturing information" of the No. 3 deterioration information. In addition, the "transmission source" of the No. 3 deterioration information is the "EV communication module", and the "transmission source" of the No. 4 deterioration information is the "slave station". That is, the No. 3 deterioration information and the No. 4 deterioration information are the deterioration information on the same power storage module 111 acquired by different modules and transmitted from different transmission sources.

In this case, the processing device 20 compares the No. 4 deterioration information with the No. 3 deterioration information. In the example of FIG. 5, the "voltage range" of both the No. 3 deterioration information and the No. 4 deterioration information is "380 V to 420 V". On the other hand, the "number of times of charging" of the No. 3 deterioration information is "5 times", and the "number of times of charging" of No. 4 is "10 times".

Although both the No. 4 deterioration information and the No. 3 deterioration information are deterioration information related to the same power storage module 111, the number of times of charging is different. This indicates that there is a possibility that the No. 4 deterioration information or the No. 3 deterioration information has been falsified.

Herein, in the case of deterioration information related to the same power storage module 111, when there is a difference in acquisition time of the deterioration information, the two pieces of deterioration information may not coincide with each other. Therefore, when the deterioration information is compared by the comparison module 24, in a case where the acquisition time of the deterioration information acquired later is later than the acquisition time of the deterioration information acquired in the past by a predetermined time or more, the processing device 20 detects a contradiction of the two pieces of deterioration information. Hereinafter, a description will be provided on the assumption that the predetermined time is one hour.

The difference between the "acquisition time" of the No. 4 deterioration information and the No. 3 deterioration information is 10 minutes. Therefore, the difference between the acquisition time of the No. 4 deterioration information and the acquisition time of the No. 3 deterioration information is less than the predetermined time, and thus the processing device 20 outputs an alert.

Then, it is assumed that the processing device 20 receives No. 5 deterioration information. The "manufacturing information" of the No. 5 deterioration information is "Company A, B0, ID0". In this case, the processing device 20 compares the deterioration information (herein, No. 1 deterioration information or No. 2 deterioration information) having the same manufacturing information with the No. 5 deterioration information. The deterioration information to be compared may be, for example, the latest deterioration information with performance data acquisition partners having different "transmission sources", among pieces of deterioration information having the same "manufacturing information". Herein, a case where the No. 2 deterioration information is compared with the No. 5 deterioration information will be described.

The "deterioration information acquisition time" of the No. 2 deterioration information is "November 1, 2024, 12:30". In addition, the "deterioration information acquisition time" of the No. 5 deterioration information is "December 1, 2024, 12:30". In this case, the acquisition time of the No. 5 deterioration information is later than the acquisition time of the No. 2 deterioration information by the predetermined time (1 hour) or more, and thus the processing device 20 detects a contradiction of the deterioration information.

First, the No. 2 deterioration information and the No. 5 deterioration information are compared with each other in "the number of times of charging". The number of times of charging is information that increases as the use time of the power storage module 111 increases. Therefore, the latest number of times of charging acquired later should be a value equal to or larger than the past number of times of charging.

Referring to the deterioration information management table, the "number of times of charging" of the No. 2 deterioration information is "10 times". In contrast, "the number of times of charging" of the No. 5 deterioration information is "20 times". That is, the past number of times of charging (10 times) ≤ the latest number of times of charging (20 times). Therefore, the number of times of charging is not contradicted.

Then, the No. 2 deterioration information and the No. 5 deterioration information are compared with each other in "voltage range". The voltage range is information that a possible range becomes wider (fluctuation increases) as the use time of the power storage module 111 increases. That is, the lower limit of the voltage range is information in which the value decreases as the use time of the power storage module 111 increases. This is because, when the use time of the power storage module 111 increases, a value smaller than the lower limit value measured once is measured, whereby the value may become the lower limit, but when a value larger than the lower limit value measured once is measured, the value does not become the lower limit. In addition, the upper limit of the voltage range is information in which the value increases as the use time of the power storage module 111 increases. This is because, when the use time of the power storage module 111 increases, a value larger than the upper limit value measured once is measured, whereby the value may become the upper limit, but when a value smaller than the upper limit value measured once is measured, the value does not become the upper limit.

That is, the lower limit of the latest voltage range acquired later should be a value less than or equal to the lower limit of the past voltage range, and the upper limit of the latest voltage range acquired later should be a value larger than or equal to the upper limit of the past voltage range.

Referring to the deterioration information management table, the lower limit of the "voltage range" of the No. 2 deterioration information is "380 V". The lower limit of the "voltage range" in the No. 5 deterioration information is "380 V". That is, the lower limit (380 V) of the past voltage range ≥ the lower limit (380 V) of the latest voltage range, and there is no contradiction as to the lower limit of the voltage range.

The upper limit of the "voltage range" in the No. 2 deterioration information is "420 V". The upper limit of the "voltage range" in the No. 5 deterioration information is "420 V". That is, the upper limit (420 V) of the past voltage range ≥ the upper limit (420 V) of the latest voltage range, and there is no contradiction as to the upper limit of the voltage range.

As described above, there is no contradiction in the number of times of charging and the voltage range. Therefore, the possibility that the No. 2 deterioration information and the No. 5 deterioration information are falsified is low, and thus the processing device 20 does not output an alert.

Then, it is assumed that the processing device 20 receives No. 6 deterioration information. The "manufacturing information" of the No. 6 deterioration information is "Company A, B0, ID0", which is the same as the No. 1, No. 2, and No. 5 deterioration information. Herein, the processing device 20 compares the No. 6 deterioration information with the No. 5 deterioration information.

The "deterioration information acquisition time" of the No. 6 deterioration information is "16:40, December 2, 2024", and is separated from the No. 5 deterioration information by the predetermined time (one hour) or more. Therefore, the processing device 20 detects contradiction in the deterioration information.

"The number of times of charging" of the No. 5 deterioration information is "20 times". In contrast, the number of times of charging of the No. 6 deterioration information is "10 times". That is, although the number of times of charging is not reduced, the past number of times of charging (20 times) > the latest number of times of charging (10 times). Therefore, there is a possibility that the No. 5 deterioration information or the No. 6 deterioration information has been falsified, and thus the processing device 20 outputs an alert.

Herein, the number of times of charging and the voltage range have been described, but contradiction can be detected by a similar method for other information on the power storage module 111. For example, information such as an operation time, a resistance value, a capacity change rate, a maximum operation temperature, and an integrated current use amount for the power storage module 111 is information in which the value increases with the lapse of time. In such information, a contradiction is detected in a case of a small value of deterioration information acquired late among the two pieces of deterioration information. In addition, for example, the information such as the SOH and the minimum operation temperature for the power storage module 111 is information in which the value decreases with the lapse of time. In such information, a contradiction is detected in a case of a larger value of deterioration information acquired late among the two pieces of deterioration information. In addition, a contradiction may be detected in consideration of a combination of a plurality of pieces of information. For example, the processing device 20 may detect that there is a contradiction in the increase/decrease amount of the SOC with respect to the operation time and the number of times of charging included in the deterioration information, or the increase/decrease amount of the capacity with respect to the operation time and the number of times of charging. The contradiction detection method allows detection in various other manners, and is not limited to the method described above.

The deterioration information to be compared may be the latest deterioration information among pieces of the deterioration information having the same manufacturing information. In this case, although the transmission source of the newly received deterioration information is the same as the transmission source of the deterioration information to be compared, the deterioration information may be used as the deterioration information to be compared as long as there is a time difference of a predetermined time or more between the two transmission sources. For example, after the deterioration information is transmitted once, when the deterioration information is falsified and the deterioration information is transmitted from the same transmission source again, there is a possibility that a contradiction is generated between the deterioration information received the first time and the deterioration information received the second time from the same transmission source. Detecting such contradiction can discover falsification of the deterioration information similarly to the above-described example. Note that the predetermined time may be different between a case where deterioration information of the same transmission source is compared and a case where deterioration information of different transmission sources is compared. In a case where the transmission sources are different from each other, when the same data is referred to, there is a possibility that the acquisition time is different due to different communication paths, and the condition of comparison is that there is a time difference of the predetermined time or more in order to absorb the time difference. On the other hand, in a case where the transmission sources are the same, the communication paths are the same, and thus, the predetermined time as a comparison condition may be made smaller than that in a case where the transmission sources are different. For example, in a case where a transmission source of newly received deterioration information is the same as a transmission source of deterioration information to be compared, a condition that a time difference between the two transmission sources is 0 may be used as a condition for comparison.

Note that the reception time in FIG. 5 is represented in units up to minutes, but may be represented in units up to seconds or may be represented at a granularity of 1 second or less.

In addition, herein, the predetermined time is set to one hour, but the present invention is not limited thereto, and may be one second or a shorter time.

The information (the comparison result) which is output by the comparison module 24 indicates that there is a possibility that the deterioration information has been falsified. The information is information indicating whether there is a possibility that the deterioration information has been falsified. The information indicating that there is a possibility that the deterioration information has been falsified may include, for example, two pieces of deterioration information themselves. The information indicating that there is a possibility that the deterioration information has been falsified may be information indicating a degree of difference between the two pieces of deterioration information.

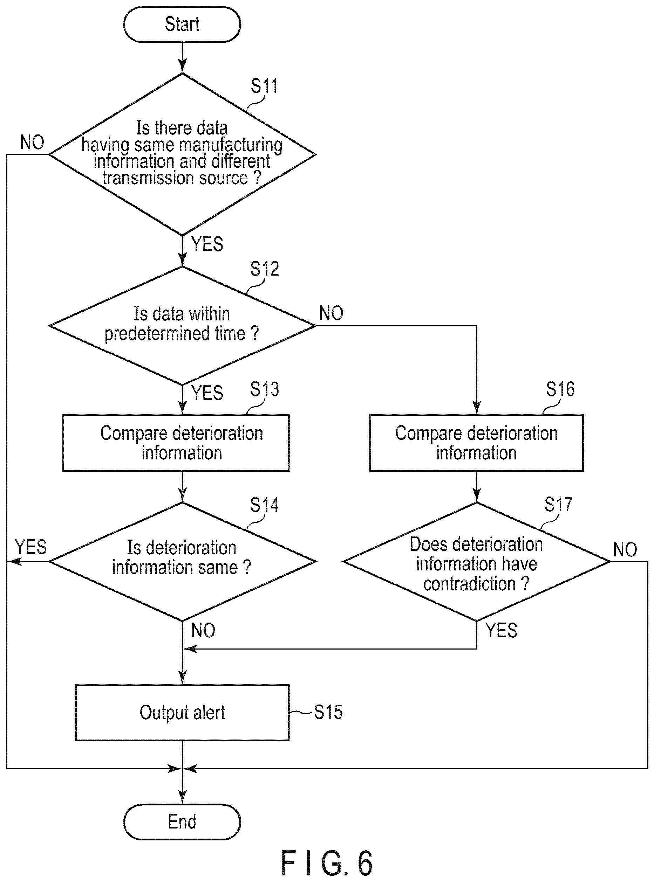

Then, an example of a flow of comparison processing of the processing device 20 will be described with reference to a flowchart of FIG. 6.

The processing device 20 starts the comparison processing in response to the reception of the deterioration information. In the following description, newly received deterioration information that is a trigger for starting the comparison processing is referred to as "new deterioration information". Note that the processing device 20 may start the comparison processing in response to the reception of a request signal for comparison of deterioration information from the EV system 10, the power storage system 11, or a terminal of a surveillance staff via the Internet 2. In this case, the comparison processing is performed for the latest deterioration information at the time point when the request signal for comparison of deterioration information is received as new deterioration information.

The controller 22 of the processing device 20 refers to the deterioration information management table to determine whether there is deterioration information (data) on the power storage module 111 which is the same deterioration information as the new deterioration information and has a different transmission source from the new deterioration information (step S11). Specifically, the controller 22 determines whether deterioration information in which "manufacturing information" of new deterioration information matches and "transmission source" is different is stored.

When the deterioration information on the same power storage module 111 as the new deterioration information is not stored or when the deterioration information with the transmission source different from that of the new deterioration information is not stored (NO in step S11), there is no target to be compared with the new deterioration information, and thus the controller 22 ends the processing.

On the other hand, when deterioration information on the power storage module 111 which is the same as the new deterioration information and has a different transmission source from the new deterioration information is stored (YES in step S11), the controller 22 determines whether the deterioration information is data acquired within a predetermined time (step S12). When a plurality of pieces of deterioration information on the power storage module 111 which is the same as the new deterioration information and has a different transmission source from the new deterioration information are stored, the controller 22 determines whether the latest deterioration information among the pieces of deterioration information is data acquired within the predetermined time. Hereinafter, deterioration information on the power storage module 111 which is the same as the new deterioration information and has a different transmission source from the new deterioration information (when a plurality of pieces of corresponding deterioration information are stored, the latest deterioration information among the plurality of pieces of corresponding deterioration information) is referred to as "deterioration information to be compared". Specifically, the controller 22 determines whether the acquisition time of the new deterioration information is within the predetermined time from the "acquisition time" of the deterioration information to be compared.

When the acquisition time of the new deterioration information is within the predetermined time from the acquisition time of the deterioration information to be compared (YES in step S12), in order to determine whether the new deterioration information matches the deterioration information to be compared, the comparison module 24 compares the two pieces of deterioration information (step S13).

When the new deterioration information matches the deterioration information to be compared (YES in step S14), there is a low possibility that the new deterioration information or the deterioration information to be compared is falsified. Therefore, the processing device 20 ends the comparison processing without outputting an alert or the like. Note that, in a case where the alert is not output, the processing device 20 may output information indicating that there is a low possibility that the new deterioration information or the deterioration information to be compared is falsified to a monitor device (not illustrated) connected to the processing device 20, or may write the information to the storage 23. Alternatively, the processing device 20 may notify the transmission source of new deterioration information (herein, the EV communication module 17), a terminal of a surveillance staff, and the like.

On the other hand, when the new deterioration information does not match the deterioration information to be compared (NO in step S14), there is a possibility that the new deterioration information or the deterioration information to be compared is falsified. Therefore, the processing device 20 outputs an alert indicating that there is a possibility that the new deterioration information or the deterioration information to be compared is falsified (step S15).

Note that, when the acquisition time of the new deterioration information is not data within the predetermined time from the acquisition time of the deterioration information to be compared (when the acquisition time of the new deterioration information is later than the acquisition time of the deterioration information to be compared by the predetermined time or more) (NO in step S12), in order to determine whether the new deterioration information and the deterioration information to be compared contradict each other, the comparison module 24 compares the two pieces of deterioration information (step S16).

The case where there is a contradiction is a case where, when comparing information based on the use time of the power storage module 111, the information included in the new deterioration information indicates that the use time of the power storage module 111 is shorter than a value of the information included in the deterioration information to be compared (deterioration information acquired earlier). For example, in a case, when information in which the value increases as the use time of the power storage module 111 increases is compared, the value of the information included in the new deterioration information is smaller than the value of the information included in the deterioration information to be compared. Alternatively, for example, in a case, when information in which the value decreases as the use time of the power storage module 111 increases is compared, the value of the information included in the new deterioration information is larger than the value of the information included in the deterioration information to be compared.

When there is a contradiction between the new deterioration information and the deterioration information to be compared (YES in step S17), the processing device 20 outputs an alert (step S15). Specifically, the comparison module 118 outputs, to the controller 22, a comparison result indicating that there is a possibility that the new deterioration information or the deterioration information to be compared has been falsified. The controller 22 generates an alert output command based on the comparison result and transmits the alert output command to the transmission destination via the communication module 21 and the Internet 2. The alert transmission destination is a monitor device (not illustrated) or a terminal of a surveillance staff. The processing device 20 may write the comparison result to the storage 23. Alternatively, the processing device 20 may notify a transmission source of the new deterioration information (herein, the EV communication module 17) that there is a possibility that the new deterioration information or the deterioration information to be compared has been falsified.

On the other hand, when there is no contradiction between the new deterioration information and the deterioration information to be compared (NO in step S17), the processing device 20 ends the process without outputting an alert.

Note that, in the above example, the new deterioration information is compared with one piece of deterioration information to be compared (past deterioration information), but the processing device 20 may compare the new deterioration information with a plurality of pieces of deterioration information to be compared.

As described above, the processing device 20 according to the first arrangement receives the first deterioration information on the power storage module 111 from the power storage controller 112 (first controller) connected to the power storage module 111, and receives the second deterioration information on the power storage module 111 from the ECU 16 (second controller) connected to the power storage controller 112 and at a higher level than the power storage controller 112. Then, the processing device 20 compares the first deterioration information with the second deterioration information, and outputs output information on whether there is a possibility that the first deterioration information or the second deterioration information has been falsified.

Specifically, when the first deterioration information does not match the second deterioration information, the processing device 20 outputs information (alert) indicating that there is a possibility that the first deterioration information or the second deterioration information has been falsified.

In addition, in a case where there is a difference of the predetermined time or more between the time when the first deterioration information is acquired and the time when the second deterioration information is acquired, and there is a contradiction between the first deterioration information and the second deterioration information, the processing device 20 outputs information (alert) indicating that there is a possibility that the first deterioration information or the second deterioration information is falsified.

With such the configuration, the processing device 20 according to the first arrangement can easily detect that the deterioration information has been falsified by the power storage controller 112 of the power storage system 11 that has acquired the first deterioration information or the ECU 16 of the EV system 10 that has acquired the second deterioration information. In addition, according to the present arrangement, an alert is automatically output when there is falsification, and thus a data manager, a monitoring organization of a third party, or the like can easily notice the falsification of the data.

Note that in the first arrangement, an example of detecting falsification of data related to the storage battery mounted in the EV has been described, but the present arrangement is also applicable to other systems operated by the power of the storage battery.

### (First modification)

Then, a first modification of the first arrangement will be described. Note that parts similar to those in the first arrangement described above are denoted by the same reference numerals, and detailed description thereof will be omitted.

An overall configuration of a storage battery system 101 according to a first modification is similar to that of the first arrangement illustrated in FIG. 1. Note that the EV system 10 according to the first modification may not include the EV communication module 17 for sending the deterioration information from the ECU 16 to the processing device 20.

A storage battery system 101 shown in FIG. 1 according to a first modification is different from the first arrangement described above in that the power storage system 11 shown in FIG. 2 includes a configuration for acquiring first deterioration information from a power storage controller 112 of a storage battery 11a and acquiring second deterioration information from a BMS 115 of the power storage system 11.

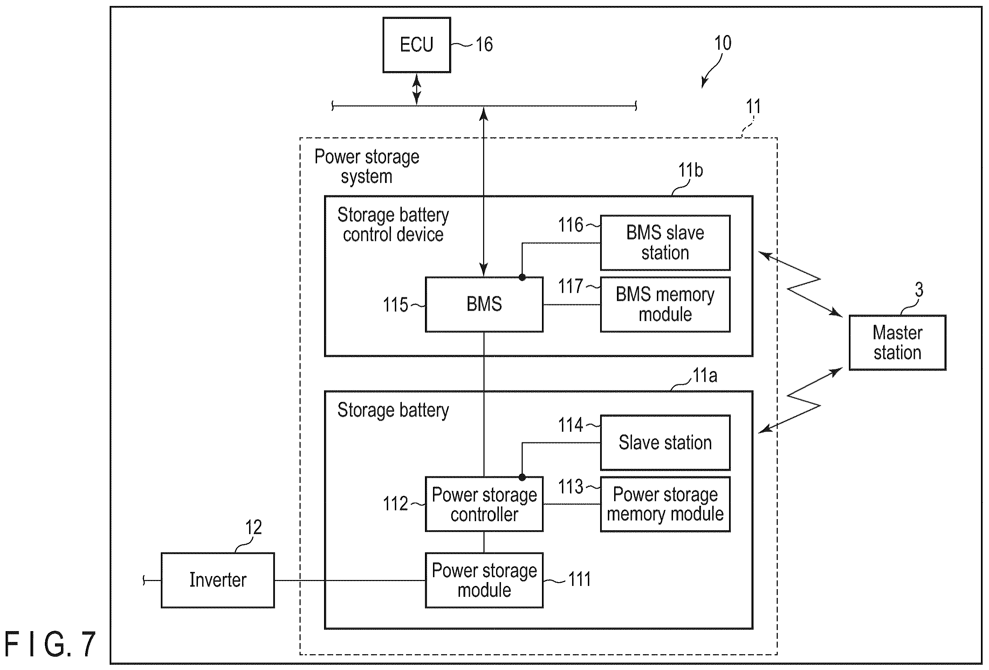

FIG. 7 is a block diagram showing a configuration example of the power storage system 11 in the first modification. The power storage system 11 in the first modification includes a storage battery 11a and a storage battery control device 11b. The configuration of the storage battery 11a is similar to that of the first arrangement. That is, the power storage controller 112 of the storage battery 11a is in a lower level than the BMS 115 of the storage battery control device 11b, and controls the charge switches and the discharge switches in response to a control command from the BMS 115. In addition, upon receiving the request signal for the deterioration information of the power storage module 111 from the processing device 20, the power storage controller 112 reads out the deterioration information (first deterioration information) of the power storage module 111 stored in the power storage memory module 113, and transmits the deterioration information to the processing device 20 through the slave station 114 and the master station 3.

The storage battery control device 11b includes a BMS slave station 116 and a BMS memory module 117 in addition to the BMS 115.

The BMS 115 outputs a control command to the charge switches and the discharge switches of each cell to the power storage controller 112 of the storage battery 11a based on the monitoring information output from the storage battery 11a and the control command output from the ECU 16 of the EV system 10. That is, the BMS 115 of the storage battery control device 11b is in a higher level than the power storage controller 112 of the storage battery 11a.

In addition, the BMS 115 outputs monitoring information or deterioration information of the power storage module 111 to the ECU 16 based on a control command output from the ECU 16.

Further, the BMS 115 in the first modification generates (counts, calculates, or detects) the above-described deterioration information based on the monitoring information of the power storage module 111 output from the storage battery 11a, and writes the deterioration information to the BMS memory module 117 together with the time information. Writing to the BMS memory module 117 may be periodically performed, or may be performed in response to a command from the ECU 16.

In addition, upon receiving the deterioration information request signal of the power storage module 111 from the processing device 20 through the master station 3 and the BMS slave station 116, the BMS 115 reads out the deterioration information (second deterioration information) of the power storage module 111 stored in the BMS memory module 117, and transmits the deterioration information to the processing device 20 via the BMS slave station 116 and the master station 3.

The configuration and processing of the processing device 20 are similar to those of the first arrangement. In the deterioration information management table stored in the storage 23 of the processing device 20, the "transmission source" is set to the "slave station" or the "BMS slave station". The fact that the "transmission source" is set to the "slave station" indicates that the deterioration information is the first deterioration information transmitted by the power storage controller 112 of the storage battery 11a. In addition, the fact that the "transmission source" is set to the "BMS slave station" indicates that the deterioration information is the second deterioration information transmitted by the BMS 115 of the storage battery control device 11b.

That is, the processing device 20 receives the first deterioration information of the power storage module 111 from the power storage controller 112 (first controller) of the storage battery 11a via the slave station 114, the master station 3, and the Internet 2. In addition, the processing device 20 acquires the second deterioration information from the BMS 115 (second controller) of the storage battery control device 11b in a higher level than the power storage controller 112 of the storage battery 11a via the BMS slave station 116, the master station 3, and the Internet 2. Then, the first deterioration information and the second deterioration information are compared by the above-described comparison processing, and output information indicating whether there is a possibility that the first deterioration information or the second deterioration information has been falsified is output.

With such a configuration, the processing device 20 according to the first modification can easily detect falsification of the deterioration information by the power storage controller 112 of the storage battery 11a that has acquired the first deterioration information or the BMS 115 of the storage battery control device 11b that has acquired the second deterioration information.

### (Second modification)

Then, a second modification of the first arrangement will be described. Note that parts similar to those in the first arrangement and the first modification described above are denoted by the same reference numerals, and detailed description thereof will be omitted.

An overall configuration of a storage battery system 101 according to the second modification is similar to that of the first arrangement illustrated in FIG. 1.

A storage battery system 101 according to the second modification is different from the above-described first arrangement in that a power storage system 11 illustrated in FIG. 2 includes a configuration for acquiring first deterioration information from a BMS 115 of a storage battery control device 11b and acquiring second deterioration information from an ECU 16 of an EV system 10.

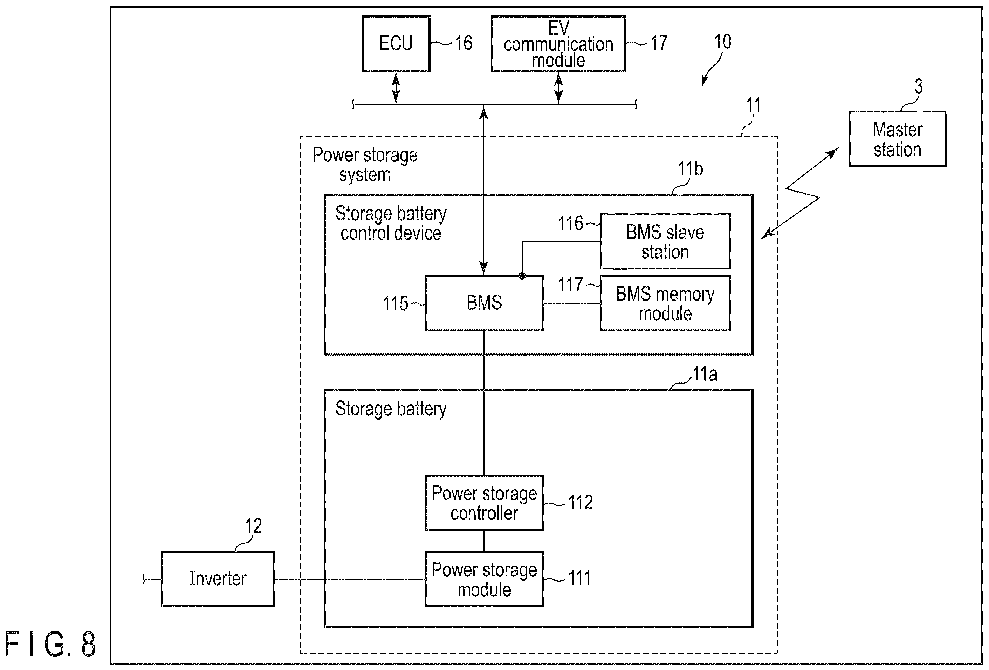

FIG. 8 is a block diagram showing a configuration example of the power storage system 11 in the second modification. The entire configuration of the storage battery system 101 according to the second modification is similar to that of the first arrangement. That is, the ECU 16 is in a higher level than the power storage system 11 (specifically, the BMS 115), and outputs a control command to the power storage system 11 to perform control for storing power in the storage battery 11a. In addition, the ECU 16 transmits information on the EV including the deterioration information (second deterioration information) of the storage battery 11a to the processing device 20 via the EV communication module 17 and the communication device 4.

The power storage system 11 in the second modification includes the storage battery 11a and a storage battery control device 11b. The storage battery 11a in the second modification does not include the power storage memory module 113 and the slave station 114, but includes only the power storage module 111 and the power storage controller 112.

The power storage module 111 is similar to that of the first arrangement. The power storage controller 112 outputs the monitored information to the storage battery control device 11b in response to a request signal from the storage battery control device 11b. Further, the power storage controller 112 controls the charge switch and the discharge switch in response to a control command from the storage battery control device 11b. The power storage controller 112 may be a CMU.

The configuration of the storage battery control device 11b includes a BMS 115, a BMS slave station 116, and a BMS memory module 117. The processing of the BMS 115, the BMS slave station 116, and the BMS memory module 117 is similar to that of the first modification described above.

That is, the BMS 115 is in a lower level than the ECU 16 of the EV system 10, and outputs the control command to the power storage controller 112 of the storage battery 11a based on the control command output from the ECU 16 of the EV system 10 and the monitoring information output from the storage battery 11a. In addition, upon receiving the deterioration information request signal of the power storage module 111 from the processing device 20, the BMS 115 reads out the deterioration information (first deterioration information) of the power storage module 111 stored in the BMS memory module 117, and transmits the deterioration information to the processing device 20 via the BMS slave station 116 and the master station 3.

The configuration and processing of the processing device 20 are similar to those of the first arrangement. In the deterioration information management table stored in the storage 23 of the processing device 20, the "transmission source" is set to the "BMS slave station" or the "EV communication module". The fact that the "transmission source" is set to the "BMS slave station" indicates that the deterioration information is the first deterioration information transmitted by the BMS 115 of the storage battery control device 11b. In addition, the fact that the "transmission source" is set to the "EV communication module" indicates that the deterioration information is the second deterioration information transmitted by the ECU 16 of the EV system 10.

That is, the processing device 20 acquires the first deterioration information from the BMS 115 (first controller) of the storage battery control device 11b via the BMS slave station 116, the master station 3, and the Internet 2. In addition, the processing device 20 receives the second deterioration information of the power storage module 111 from the ECU 16 (second controller) of the EV system 10 in the upper-level than the BMS 115 of the storage battery control device 11b via the EV communication module 17, the communication device 4, and the Internet 2. Then, the first deterioration information and the second deterioration information are compared by the above-described comparison processing, and output information indicating whether there is a possibility that the first deterioration information or the second deterioration information has been falsified is output.

With such a configuration, the processing device 20 according to the second modification can easily detect falsification of the deterioration information by the BMS 115 of the storage battery control device 11b that has acquired the first deterioration information or the ECU 16 of the EV system 10 that has acquired the second deterioration information.

### (Second arrangement)

Then, a second arrangement will be described. The second arrangement is different from the first arrangement described above in that the power storage system is used in an uninterruptible power supply (UPS) system instead of the EV system 10.

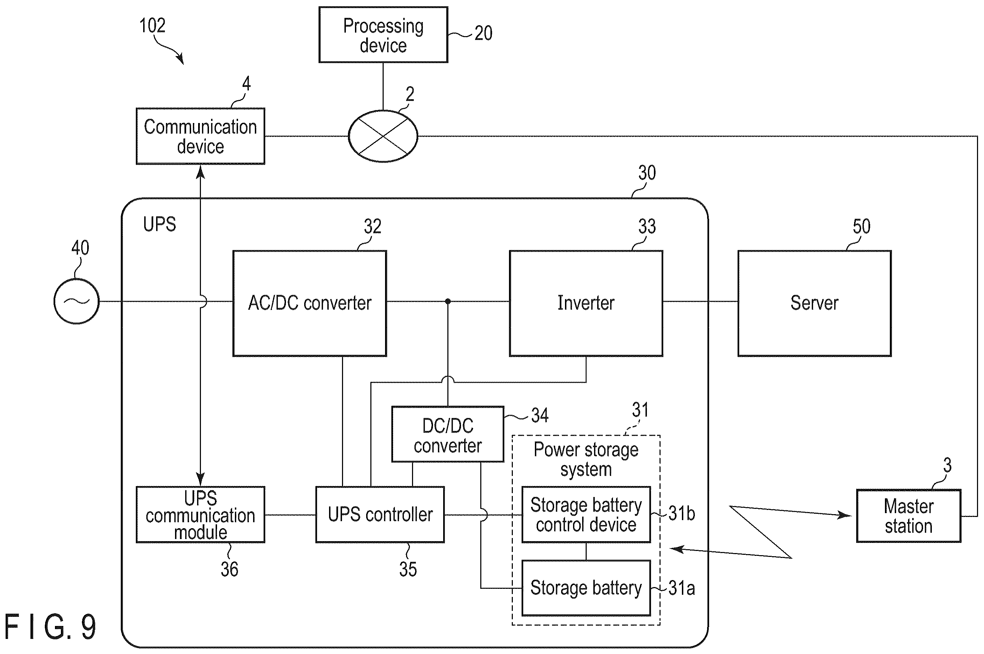

FIG. 9 is a diagram illustrating a configuration example of a storage battery system 102 according to the second arrangement. Note that parts similar to those in the first arrangement described above are denoted by the same reference numerals, and detailed description thereof will be omitted.

The storage battery system 102 according to the second arrangement includes a processing device 20, a master station 3, a communication device 4, a UPS system 30, a system power supply 40, and a server (load) 50. The UPS system 30 is communicably connected to the communication device 4 by wire. The communication device 4 is communicably connected to the processing device 20 via the Internet 2. In addition, the UPS system 30 is communicably connected to the master station 3 by wireless. The master station 3 is communicably connected to the processing device 20 via the Internet 2.

The UPS system 30 is a device that supplies power to an external device such as a server 50 by storing power supplied from the system power supply 40 when a failure such as a power failure occurs. The UPS system 30 includes, for example, a power storage system 31, an AC/DC converter 32, an inverter 33, a DC/DC converter 34, a UPS controller 35, and a UPS communication module 36.

The AC/DC converter 32 performs rectification, smoothing, and transformation on the AC voltage input from the system power supply 40, and converts the AC voltage into a DC voltage. Then, the AC/DC converter 32 outputs the converted DC voltage to the DC/DC converter 34.

The DC/DC converter 34 steps down or steps up the DC voltage input from the AC/DC converter 32, and outputs the converted DC voltage to the power storage system 31. The DC/DC converter 34 steps up or down the DC voltage input from the power storage system 31, and outputs the converted DC voltage to the inverter 33.

The inverter 33 converts a voltage of a DC voltage output from the AC/DC converter 32 or the DC/DC converter 34, controls a frequency, converts the voltage into an AC voltage, and outputs the AC voltage to the server 50.

The UPS controller 35 controls the UPS communication module 36, the AC/DC converter 32, the inverter 33, and the power storage system 31. The UPS controller 35 normally outputs a command to the AC/DC converter 32, the inverter 33, and the power storage system 31 to store power in the power storage system 31 while supplying power from the system power supply 40 to the server 50, and when the system power supply 40 is abnormal, the UPS controller 35 outputs a command to the AC/DC converter 32, the inverter 33, and the power storage system 31 to switch to supply power from the power storage system 31 to the server 50 when the system power supply 40 is abnormal. That is, in the second arrangement, it can be said that the UPS controller 35 is in a higher level than the power storage system 31.

Specifically, the UPS controller 35 monitors the input level of the power input from the system power supply 40 to the AC/DC converter 32 or the output level of the power from the AC/DC converter 32, and measures the level of the input power supply. When the UPS controller 35 detects that the level of the input power supply has dropped below the normal value or that the frequency of the input power supply has dropped below the normal value, the power supply source to the server 50 is switched from the system power supply 40 to the power storage system 31. More specifically, the UPS controller 35 outputs a command for switching from charging to power supply to the power storage system, and outputs a command for stopping output to the inverter 33 and the DC/DC converter 34 to the AC/DC converter 32.

Thereafter, when detecting that the level of the input power supply is a normal value or the frequency of the input power supply is a normal value, the UPS controller 35 switches the power supply source to the server 50 from the power storage system 31 to the system power supply 40. Specifically, a command for switching from power supply to charging is output to the power storage system 31, and a command for starting output to the inverter 33 and the DC/DC converter 34 is output to the AC/DC converter 32.

Note that the AC/DC converter 32 and the inverter 33 may operate autonomously by a controller (not illustrated) provided in each of the AC/DC converter 32 and the inverter 33 based on an output of a sensor (not illustrated) provided in each of the AC/DC converter 32 and the inverter 33 without requiring control from the UPS controller 35.

In addition, the DC/DC converter 34 may be included in other components such as the power storage system 31 or may not be included.

Further, the UPS controller 35 transmits information on the UPS to the processing device 20 via the UPS communication module 36 and the communication device 4. The information on the UPS includes deterioration information (second deterioration information) of the storage battery 31a (more specifically, a power storage module to be described later) provided in the UPS and time information indicating the time when the deterioration information of the storage battery 31a is acquired.

The communication device 4 receives information on the UPS via the UPS communication module 36 and transmits the information to the processing device 20 via the Internet 2.

The master station 3 receives information of the UPS via the slave station included in the power storage system 31 and transmits the information to the processing device 20 via the Internet 2. The master station 3 may be, for example, a BLE master station (master), and the slave station may be, for example, a BLE slave station (slave) .

The configuration of the power storage system 31 is similar to that of the first arrangement shown in FIG. 2. Specifically, the storage battery 31a includes a power storage module, a power storage controller, a slave station, and a power storage memory module. The power storage controller controls the charge switches and the discharge switches in response to a control command from the storage battery control device. In addition, similarly to the first arrangement, the power storage controller writes monitoring information of the power storage module and deterioration information of the power storage module together with time information to the power storage memory module. Further, the power storage controller outputs monitoring information to the storage battery control device in response to a request signal from the storage battery control device. Similarly, the power storage controller transmits monitoring information of the power storage module and deterioration information (first deterioration information) of the power storage module to the processing device 20 in response to a request signal from the processing device 20.

In addition, in the power storage controller, the storage battery control device 11b includes a BMS. In the second arrangement, the BMS of the storage battery control device 11b outputs a control command to the charge switch and the discharge switch of each cell to the power storage controller of the storage battery 31a based on the monitoring information output from the storage battery 31a and the control command output from the UPS controller 35 of the UPS system 30. In addition, the BMS outputs monitoring information or deterioration information of the power storage module to the UPS controller 35 based on the control command output from the UPS controller 35.

That is, the power storage controller of the storage battery 31a is controlled (indirectly) by the UPS controller 35 of the UPS system 30 via the BMS of the storage battery control device 31b. That is, it can be said that the power storage controller of the storage battery 31a is in a lower level than the UPS controller 35 of the UPS system 30.

The configuration and comparison processing of the processing device 20 are similar to those of the first arrangement. That is, the processing device 20 compares the first deterioration information received from the power storage controller of the storage battery 31a with the second deterioration information received from the UPS controller 35 of the UPS system 30 in a higher level than the power storage controller of the storage battery 31a, and outputs an alert indicating that there is a possibility that the first deterioration information or the second deterioration information has been falsified when the first deterioration information and the second deterioration information do not match or contradict each other.

The configuration of the power storage system 31 may be a mode in which the storage battery control device 31b includes a BMS slave station and a BMS memory module as in the first modification illustrated in FIG. 7. In this case, the processing device 20 compares the first deterioration information transmitted from the power storage controller of the storage battery 31a with the second deterioration information transmitted from the BMS of the storage battery control device 31b in a higher level than the power storage controller of the storage battery 31a.

In addition, in the configuration of the power storage system 31, as in the second modification illustrated in FIG. 8, the storage battery control device 31b may include the BMS slave station and the BMS memory module, and the storage battery 31a may not include the slave station and the memory module. In this case, the processing device 20 compares the first deterioration information transmitted from the BMS of the storage battery control device 31b with the second deterioration information transmitted from the UPS controller 35 of the UPS system 30 in a higher level than the BMS of the storage battery control device 31b.

As described above, according to the second arrangement, it is possible to easily detect falsification of the first deterioration information or the second deterioration information not only in the system that operates by the power of the storage battery such as the EV but also in the system that stores the power supplied from the power system such as the UPS in the storage battery.

### (Third arrangement)

Then, a third arrangement will be described. The third arrangement is different from the first and second arrangements described above in that not the processing device 20 but the power storage system 11 compares the first deterioration information and the second deterioration information. Note that parts similar to those in the first arrangement and the second arrangement described above are denoted by the same reference numerals, and detailed description thereof will be omitted.

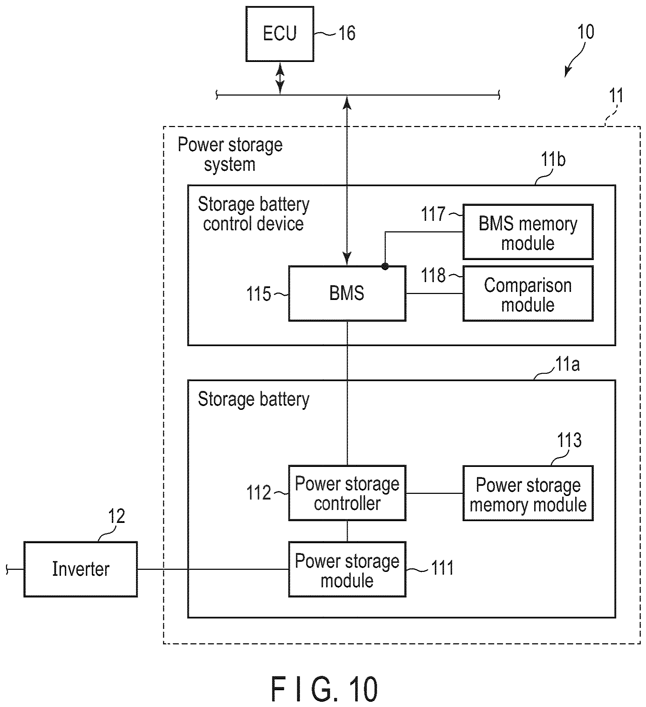

FIG. 10 is a block diagram illustrating a configuration example of a power storage system 11 according to the third arrangement. In the following description, the power storage system 11 will be described as being incorporated in the EV system 10 illustrated in FIG. 1, but the power storage system 11 may be incorporated in the UPS system 30 illustrated in FIG. 9.

The power storage system 11 includes the storage battery 11a and a storage battery control device 11b. The storage battery 11a in the third arrangement includes a power storage module 111, a power storage controller 112, and a power storage memory module 113.

The power storage module 111 is similar to that of the first arrangement. The power storage controller 112 controls the charge switches and the discharge switches in response to a control command from the storage battery control device 11b. That is, it can be said that the power storage controller 112 is in a lower level than the storage battery control device 11b.

In addition, the power storage controller 112 writes monitoring information of the power storage module 111 and deterioration information of the power storage module 111 generated based on the monitoring information together with time information in the power storage memory module 113. Further, the power storage controller 112 outputs monitoring information or deterioration information of the power storage module 111 to the storage battery control device 11b in response to a request signal from the storage battery control device 11b.

Under the control of the power storage controller 112, the power storage memory module 113 stores monitoring information of the power storage module 111 and deterioration information of the power storage module 111 together with time information.

The storage battery control device 11b includes a BMS 115, a BMS memory module 117, and a comparison module 118. The BMS 115 outputs a control command to the charge switches and the discharge switches of each cell to the power storage controller 112 of the storage battery 11a based on the monitoring information output from the storage battery 11a and the control command output from the ECU 16 of the EV system 10. That is, it can be said that the BMS 115 is in a higher level than the power storage controller 112 of the storage battery 11a. In addition, the BMS 115 outputs monitoring information to the ECU 16 based on a request signal output from the ECU 16.

In addition, the BMS 115 generates (counts, calculates, or detects) deterioration information of the power storage module 111 based on the monitoring information output from the storage battery 11a, and writes the deterioration information to the BMS memory module 117 together with time information.

The BMS memory module 117 stores deterioration information of the power storage module 111 together with time information under the control of the BMS 115. Herein, the BMS memory module 117 is controlled by the BMS 115 in a higher level than the storage battery 11a, and thus it can be said that the BMS memory module 117 is in a higher level than the power storage memory module 113 of the storage battery 11a. In other words, the power storage memory module 113 of the storage battery 11a is controlled by the power storage controller 112 in a lower level than the storage battery control device 11b, and thus it can be said that it is in a lower level than the BMS memory module 117.

The comparison module 118 transmits a request signal of the deterioration information of the power storage module 111 stored in the power storage memory module 113 to the storage battery 11a in response to a control command of the ECU 16 of the EV system 10 as a trigger. In this case, the comparison module 118 acquires, for example, deterioration information of the latest power storage module 111 stored in the power storage memory module 113. Then, the comparison module 118 compares the deterioration information (second deterioration information) of the power storage module 111 stored in BMS memory module 117 (first memory module) with the deterioration information (first deterioration information) of the power storage module 111 stored in the power storage memory module 113 (second memory module) in a lower level than the BMS memory module 117. The comparison processing is similar to the comparison processing described above with reference to FIGS. 5 and 6.

When the comparison processing is performed using the deterioration information management table in FIG. 5, there is no field indicating "reception time" in the deterioration information management table in FIG. 5, and the BMS memory module or the power storage memory module is set in "transmission source".

Although it has been described herein that the BMS 115 generates the deterioration information of the power storage module 111 based on the monitoring information acquired from the power storage controller 112, the BMS 115 may acquire and store the deterioration information of the power storage module 111 generated by the power storage controller 112.

In addition, the BMS memory module 117 may store deterioration information of the power storage module 111 output from the ECU 16 or deterioration information of the power storage module 111 generated by the BMS 115 based on monitoring information output from the ECU 16.

According to the third arrangement, falsification of the deterioration information of the power storage module 111 can be easily found by comparing the first deterioration information stored in the power storage memory module 113 or the second deterioration information stored in the BMS memory module 117 without providing the processing device 20.

According to at least one arrangement described above, it is possible to provide a processing device, a storage battery system, and a storage battery control device capable of easily finding falsification of data on a storage battery.

While certain arrangements have been described, these arrangements have been presented by way of example only, and are not intended to limit the scope of the claims. Indeed, the processing device described herein may be embodied in a variety of other forms; furthermore, various omissions, substitutions and changes in the form of the processing device described herein may be made.

The arrangements as described above include clauses below.

### Clause 1

A processing device (20), characterized by comprising:
receiving first deterioration information on a power storage module (111) from a first controller (112) connected to the power storage module (111);
receiving second deterioration information on the power storage module (111) from a second controller (16) that is connected to the first controller (112) and directly or indirectly controls the first controller (112); and
comparing the first deterioration information with the second deterioration information, and outputs output information on whether there is a possibility that the first deterioration information or the second deterioration information has been falsified.

### Clause 2

The processing device (20) according to claim 1, characterized in that
the second controller (16) controls a system (10) operated by electric power of the power storage module (111).

### Clause 3

The processing device (20) according to claim 2, characterized in that
the system (10) includes the first controller (112).

### Clause 4

The processing device (20) according to claim 1, characterized in that
the second controller (35) controls a system (30) that is connected to a power system (40) and stores electric power supplied from the power system (40) in the power storage module (111).

### Clause 5

The processing device (20) according to claim 4, characterized in that
the system (40) includes the first controller (112).

### Clause 6

The processing device (20) according to claim 1, characterized in that
when the first deterioration information does not match the second deterioration information, the output information includes information indicating that there is a possibility that the first deterioration information or the second deterioration information has been falsified.

### Clause 7

The processing device (20) according to claim 1, characterized in that
when there is a difference of a predetermined time or more between a time when the first deterioration information is acquired and a time when the second deterioration information is acquired, and when there is a contradiction between the first deterioration information and the second deterioration information,
the output information includes information indicating that there is a possibility that the first deterioration information or the second deterioration information has been falsified.

### Clause 8

The processing device (20) according to claim 7, characterized in that
the first deterioration information and the second deterioration information each include information based on a use time of the power storage module (111), and includes information indicating that deterioration information acquired later among the first deterioration information and the second deterioration information has a shorter use time of the power storage module (111) than the deterioration information acquired earlier when there is the contradiction between the first deterioration information and the second deterioration information.

### Clause 9

The processing device according to claim 1, characterized in that
the first controller (112) reads the first deterioration information from a storage (113) connected to the first controller (112) and transmits the first deterioration information, and
the second controller (16) reads the second deterioration information from a storage connected to the second controller (16) and transmits the second deterioration information.

### Clause 10

A storage battery system (101) characterized by comprising:
a power storage module (111);
a first controller (112) connected to the power storage module (111);
a second controller (16) connected to the first controller (112) and configured to directly or indirectly control the first controller (112); and
a processing device (20) capable of communicating with the first controller (112) and the second controller (16), respectively, wherein
the first controller (112) transmits first deterioration information on the power storage module to the processing device (20),
the second controller (16) transmits second deterioration information on the power storage module (111) received from the first controller (112) to the processing device (20), and
the processing device (20) compares the first deterioration information with the second deterioration information, and outputs output information on whether there is a possibility that the first deterioration information and the second deterioration information have been falsified.

### Clause 11

A storage battery control device (11b-Figure 10), characterized by comprising:
a second controller (115) connected to a power storage module (111);
a first memory module (117) that stores second deterioration information on the power storage module (111); and
a comparison module (118) that compares the second deterioration information stored in the first memory module (117) with first deterioration information on the power storage module (111) stored in a second memory module (113) different from the first memory module (117) by a first controller (112) controlled by the second controller (115), wherein
the second controller (115) outputs output information on whether there is a possibility that the first deterioration information or the second deterioration information has been falsified, based on a comparison result by the comparison module (118).

## Claims

1. A processing device (20), **characterized by** comprising:
receiving first deterioration information on a power storage module (111) from a first controller (112) connected to the power storage module (111);
receiving second deterioration information on the power storage module (111) from a second controller (16) that is connected to the first controller (112) and directly or indirectly controls the first controller (112); and
comparing the first deterioration information with the second deterioration information, and outputs output information on whether there is a possibility that the first deterioration information or the second deterioration information has been falsified.

2. The processing device (20) according to claim 1, **characterized in that**
the second controller (16) controls a system (10) operated by electric power of the power storage module (111).

3. The processing device (20) according to claim 2, **characterized in that**
the system (10) includes the first controller (112).

4. The processing device (20) according to claim 1, **characterized in that**
the second controller (35) controls a system (30) that is connected to a power system (40) and stores electric power supplied from the power system (40) in the power storage module (111).

5. The processing device (20) according to claim 4, **characterized in that**
the system (40) includes the first controller (112).

6. The processing device (20) according to claim 1, **characterized in that**
when the first deterioration information does not match the second deterioration information, the output information includes information indicating that there is a possibility that the first deterioration information or the second deterioration information has been falsified.

7. The processing device (20) according to claim 1, **characterized in that**
when there is a difference of a predetermined time or more between a time when the first deterioration information is acquired and a time when the second deterioration information is acquired, and when there is a contradiction between the first deterioration information and the second deterioration information,
the output information includes information indicating that there is a possibility that the first deterioration information or the second deterioration information has been falsified.

8. The processing device (20) according to claim 7, **characterized in that**
the first deterioration information and the second deterioration information each include information based on a use time of the power storage module (111), and includes information indicating that deterioration information acquired later among the first deterioration information and the second deterioration information has a shorter use time of the power storage module (111) than the deterioration information acquired earlier when there is the contradiction between the first deterioration information and the second deterioration information.

9. The processing device according to claim 1, **characterized in that**
the first controller (112) reads the first deterioration information from a storage (113) connected to the first controller (112) and transmits the first deterioration information, and
the second controller (16) reads the second deterioration information from a storage connected to the second controller (16) and transmits the second deterioration information.

10. A storage battery system (101) **characterized by** comprising:
a power storage module (111);
a first controller (112) connected to the power storage module (111);
a second controller (16) connected to the first controller (112) and configured to directly or indirectly control the first controller (112); and
a processing device (20) capable of communicating with the first controller (112) and the second controller (16), respectively, wherein
the first controller (112) transmits first deterioration information on the power storage module to the processing device (20),
the second controller (16) transmits second deterioration information on the power storage module (111) received from the first controller (112) to the processing device (20), and
the processing device (20) compares the first deterioration information with the second deterioration information, and outputs output information on whether there is a possibility that the first deterioration information and the second deterioration information have been falsified.

11. A storage battery control device (11b-Figure 10), **characterized by** comprising:
a second controller (115) connected to a power storage module (111);
a first memory module (117) that stores second deterioration information on the power storage module (111); and
a comparison module (118) that compares the second deterioration information stored in the first memory module (117) with first deterioration information on the power storage module (111) stored in a second memory module (113) different from the first memory module (117) by a first controller (112) controlled by the second controller (115), wherein
the second controller (115) outputs output information on whether there is a possibility that the first deterioration information or the second deterioration information has been falsified, based on a comparison result by the comparison module (118).
